# EUROPEAN PATENT APPLICATION

(11) **EP 4 693 412 A1**
(43) Date of publication of application: **11.02.2026**
(21) Application number: 23929954.8
(22) Date of filing: 15.11.2023
(51) Int. Cl.: H01L 31/0224

(54) **GRID-STACKED SOLAR CELL SHEET, SOLAR CELL AND PHOTOVOLTAIC MODULE**

(30) Priority: 28.03.2023 CN 202320640287 U
(71) Applicant: Changzhou Shichuang Energy Co., Ltd, Changzhou, Jiangsu 213300 (CN)
(72) Inventor: CHEN, Zhangyang, Pingxiang, Jiangxi 337000 (CN); ZHAO, Tianpeng, Nanjing, Jiangsu 210000 (CN); MENG, Xiangmin, Xuzhou, Jiangsu 221300 (CN); CAO, Yuhong, Nanjing, Jiangsu 211100 (CN); FU, Liming, Hangzhou, Zhejiang 310000 (CN)
(74) Representative: Miller, Ronald Anthony
(86) International application number: PCT/CN2023/131667
(87) International publication number: WO 2024/198385

(57) **Abstract**

The present invention provides a stacked grid solar cell sheet, a solar cell, and a photovoltaic module, and belongs to the technical field of photovoltaics. The stacked grid solar cell sheet includes a cell sheet substrate. A stacked grid structure is provided on a first surface of the cell sheet substrate. The stacked grid structure includes grid lines and metal wires, where the grid lines are provided on the cell sheet substrate and distributed parallel to each other at equal intervals, and the metal wires respectively cover the grid lines. A second stacked grid structure, a conventional electrode structure, or a back electrode is provided on a second surface of the cell sheet substrate. At least one current collection structure is provided on the cell sheet substrate. A current collection structure of the at least one current collection structure is perpendicularly connected to the metal wires. The stacked grid solar cell sheet may solve problems such as shading of light by a probe array and distorted conversion efficiency during testing, to reduce the difficulty during testing. The stacked grid solar cell sheet may solve the problem of inconsistency in actual electricity generation performance between solar cells in a module due to processes such as soldering, and ensure that the solar cell sheets have more consistent electrical performance, thereby effectively reducing the risk of module mismatch and providing a great practical application value.

## Description

### TECHNICAL FIELD

The present invention belongs to the technical field of photovoltaics, and specifically relates to a stacked grid solar cell sheet, a solar cell, and a photovoltaic module.

### BACKGROUND

A process for manufacturing a photovoltaic module mainly includes testing and sorting, dicing, tabbing, stringing, layup, lamination, and sealant sealing and framing of solar cells. With the development of solar cells, 18-busbar (18BB) solar cells, 30-busbar (30BB) solar cells, and even busbarless solar cells have been developed, making it considerably difficult for the subsequent testing, sorting, and stringing of solar cells.

In the subsequent testing and sorting process of solar cells, due to the shading of light by a probe array, the photo-generated current has to be transmitted to the probe array or steel wires through interconnected fingers to be collected during the testing of multi-busbar solar cells or busbarless solar cells. However, as multi-busbar solar cells are in fact constantly developing to have increasingly smaller finger heights, the transmission path of the photo-generated current from fingers to a few of busbars pressed by probes during the testing and sorting of multi-busbar solar cells becomes very long, and therefore, line loss increases, which may lead to distortion of electrical performance data obtained during the testing. In addition, during the stringing of multi-busbar solar cells, the number of spools of solder ribbons required for pay-off is increased, the number of solder ribbon clamps required is increased, and the difficulty of determining the positions of busbars on the solar cells is increased, leading to an increased difficulty in aligning the solder ribbons with the busbars.

In a conventional process for manufacturing a photovoltaic module, solar cells of the same grade are selected to manufacture a photovoltaic module, such that the electricity generation units in the photovoltaic module have relatively consistent performance, thereby reducing the power loss caused by module mismatch due to the use of solar cells of different grades. However, abnormalities such as minor busbar exposure, dry solder joints, varying degrees of shading of light, and solder flux crystallization in the solar cell soldering process and other processes will aggravate the differences in actual electricity generation performance between the solar cells after these processes, leading to a further increase in the power loss caused by module mismatch.

Moreover, in the above cell sheet structures, silver grid lines are needed to conduct the current in the transverse direction, which requires that the cross-sectional area of the silver grid lines should not be too small, otherwise the electrical resistance of the silver grid lines will be large and the loss caused by electrical resistance will be high. However, as silver paste accounts for the highest proportion of non-silicon costs in solar cell manufacturing, there is an urgent need to reduce silver consumption amidst the rapid expansion of the photovoltaic industry. Therefore, it is necessary to provide a solar cell sheet capable of greatly reducing the consumption of silver paste and reducing the difficulty of testing, sorting, and soldering processes of solar cell sheets.

### SUMMARY

### Technical problems

### Technical Solutions

To overcome the shortcomings in the prior art, the present invention provides a stacked grid solar cell sheet, a solar cell, and a photovoltaic module. The stacked grid solar cell sheet may greatly reduce the silver paste consumption of the solar cell sheet. The stacked grid solar cell sheet may reduce the difficulty in aligning solder ribbons with grid lines during the cell sheet soldering process, thereby effectively simplifying the stringing process in the photovoltaic module manufacturing process. The stacked grid solar cell sheet may solve problems such as shading of light by a probe array and distorted conversion efficiency during solar cell testing, to reduce the difficulty during testing. The stacked grid solar cell sheet may solve the problem of inconsistency in actual electricity generation performance between solar cells in a module due to processes such as soldering after solar cell grading, and ensure that the electricity generation units have more consistent electrical performance, thereby effectively reducing the risk of module mismatch and providing a great practical application value.

To achieve the above technical objective, the following technical means is adopted in the present invention.

The present invention provides a stacked grid solar cell sheet, including a cell sheet substrate,
where a stacked grid structure is provided on a first surface of the cell sheet substrate, and the stacked grid structure includes grid lines and metal wires, where the grid lines are provided on the cell sheet substrate and distributed parallel to each other at equal intervals, and the metal wires respectively cover the grid lines;
a second stacked grid structure, a conventional electrode structure, or a back electrode is provided on a second surface of the cell sheet substrate; and
at least one current collection structure is provided on the cell sheet substrate, and a current collection structure of the at least one current collection structure is perpendicularly connected to the metal wires. The conventional electrode structure is a conventional electrode structure including fingers and busbars.

Preferably, the cell sheet substrate has a shape of a rectangle, and a length of a shorter side of the rectangle is 1/3 to 2/3 of a length of a longer side of the rectangle.

Preferably, the metal wires are located within the cell sheet substrate or extend beyond the cell sheet substrate.

Preferably, a length by which the metal wires extend beyond the cell sheet substrate is adjustable as necessary.

Preferably, when the metal wires extend beyond the cell sheet substrate, the current collection structure is soldered to portions of the metal wires extending beyond the cell sheet substrate; and
when the metal wires are located within the cell sheet substrate, the current collection structure is soldered within the cell sheet substrate.

Preferably, the at least one current collection structure includes any one selected from the group consisting of a bus ribbon, a silver electrode, an electrically conductive adhesive, and an electrically conductive tape.

Preferably, the bus ribbon is connected to the metal wires by soldering, and the soldering includes any one selected from the group consisting of a manual soldering, a tabbing with a stringing machine, a roller winding-soldering, and a novel soldering.

Preferably, when the stacked grid structure is provided on the first surface of the cell sheet substrate of the stacked grid solar cell sheet and the second stacked grid structure is provided on the second surface of the cell sheet substrate of the stacked grid solar cell sheet, the metal wires on the first surface are staggered with metal wires on the second surface.

Preferably, when the stacked grid structure is provided on the first surface of the cell sheet substrate and the conventional electrode structure is provided on the second surface of the cell sheet substrate, one or two current collection structures are provided on the cell sheet substrate;
when the one current collection structure is provided, the one current collection structure is perpendicularly connected to the metal wires of the stacked grid structure; and
when the two current collection structures are provided, the two current collection structures are perpendicularly connected to the metal wires of the stacked grid structure and busbars of the conventional electrode structure, respectively.

Preferably, when the stacked grid structure is provided on the first surface of the cell sheet substrate and the back electrode is provided on the second surface of the cell sheet substrate, two current collection structures are provided on the cell sheet substrate, where one of the two current collection structures is perpendicularly connected to the metal wires of the stacked grid structure, and the other of the two current collection structures is arranged on the back electrode.

The present invention further provides a solar cell including the stacked grid solar cell sheet as described above.

Preferably, the solar cell includes a passivated emitter and rear contact (PERC) solar cell, a tunnel oxide passivated contact (TOPCon) solar cell, a heterojunction with intrinsic thin layer (HJT) solar cell, or an interdigitated back contact (IBC) solar cell.

The present invention further provides a photovoltaic module obtained by stringing at least two cell units. Each of the at least two cell units includes the stacked grid solar cell sheet or the solar cell as described above.

Preferably, two adjacent ones of the at least two cell units are connected via the current collection structure, where a current collection structure of a cell unit of the at least two cell units is connected to metal wires or a current collection structure of a subsequent adjacent cell unit of the at least two cell units by soldering.

Preferably, the current collection structure of the cell unit is arranged between the cell unit and the subsequent adjacent cell unit or is arranged on the subsequent adjacent cell unit.

### Advantages

Compared with the prior art, the present invention has the following advantages.

In the present invention, the cell sheet substrate, the metal wires, and the current collection structure are soldered together to form a stacked grid solar cell sheet as a whole, which is directly used in the subsequent photovoltaic module manufacturing process. As such, with no need to accurately determine the positions of grid lines as in conventional stringing, a photovoltaic module may be obtained by connecting the cell units, such that the difficulty in forming a solar cell string is reduced. Because the cell sheet substrate of the present invention has a shape of a rectangle and the length of the shorter side of the rectangle is about half the length of the longer side of the rectangle, cell cutting is no longer required in the photovoltaic module manufacturing process, such that the process is simplified and the loss caused by cutting is avoided.

According to the stacked grid solar cell sheet of the present invention, the solar cell is subjected to soldering in advance and a transverse current collection structure or other connection structure is arranged, such that a solar cell string of the stacked grid solar cell sheets may be obtained by connecting the connection structures without soldering the solar cells again. This may reduce the risk that the aggravation of the difference in actual electricity generation performance between solar cells due to various process abnormalities in the soldering and other processes cannot be detected after testing and grading, and consequently the difference in electrical performance between the electricity generation cell sheets in the module is aggravated, and ensures that the electricity generation cell sheets in the module formed by the stacked grid solar cell sheets of the present invention have more consistent electrical performance, thereby effectively reducing the risk of module mismatch.

According to the stacked grid solar cell sheet of the present invention, the solar cell is subjected to soldering first, and the stacked grid solar cell sheet is tested through the connection structure. In other words, the cell testing process is performed after the soldering process of the photovoltaic module manufacturing process. As such, the quality of soldering may be checked while performing cell testing, and the difficulty of cell testing is reduced. The sorting and testing of the stacked grid solar cell sheet are simpler than those of multi-busbar and busbarless solar cells in the prior art, and true values of electrical performance data of the solar cell may be measured.

### BRIEF DESCRIPTION OF THE DRAWINGS

FIG. 1 is a schematic structural view of a stacked grid solar cell sheet in which a stacked grid structure is provided on each of two surfaces of a cell sheet substrate and a bus ribbon is soldered to portions of metal wires on the front surface that extend beyond the cell sheet substrate.
FIG. 2 is a schematic structural view of a stacked grid solar cell sheet in which a stacked grid structure is provided on each of two surfaces of a cell sheet substrate and a bus ribbon is soldered to portions of metal wires on the front surface that extend beyond the cell sheet substrate, where the metal wires on the two surfaces of the stacked grid solar cell sheet are staggered with each other.
FIG. 3 is a schematic structural view of a stacked grid solar cell sheet in which a stacked grid structure is provided on each of two surfaces of a cell sheet substrate and a bus ribbon is soldered to portions of metal wires on the front surface that are located within the cell sheet substrate.
FIG. 4 is a schematic structural view of a stacked grid solar cell sheet in which a stacked grid structure is provided on each of two surfaces of a cell sheet substrate and a bus ribbon is soldered to portions of metal wires on each of the two surfaces that extend beyond the cell sheet substrate.
FIG. 5 is a schematic structural view of a stacked grid solar cell sheet in which a stacked grid structure is provided on each of two surfaces of a cell sheet substrate, a bus ribbon is soldered to portions of metal wires on one of the two surfaces that extend beyond the cell sheet substrate, and another bus ribbon is soldered to portions of metal wires on the other surface that are located within the cell sheet substrate.
FIG. 6 is a schematic structural view of a stacked grid solar cell sheet in which a stacked grid structure is provided on each of two surfaces of a cell sheet substrate and a bus ribbon is soldered to portions of metal wires on each of the two surfaces that do not extend beyond the cell sheet substrate.
FIG. 7 is a schematic structural view of a stacked grid solar cell sheet in which a stacked grid structure is provided on each of two surfaces of a cell sheet substrate, a bus ribbon is soldered to portions of metal wires on the front surface that extend beyond the cell sheet substrate, and a silver electrode is soldered on the back surface.
FIG. 8 is a schematic structural view of a stacked grid solar cell sheet in which a stacked grid structure is provided on each of two surfaces of a cell sheet substrate, a silver electrode is provided on the front surface, and a bus ribbon is provided on the back surface.
FIG. 9 is a schematic structural view of a stacked grid solar cell sheet in which a stacked grid structure is provided on each of two surfaces of a cell sheet substrate and a silver electrode is provided on each of the two surfaces.
FIG. 10 is a schematic structural view of a stacked grid solar cell sheet in which a stacked grid structure is provided on the front surface, a conventional electrode structure is provided on the back surface, and only one current collection structure is provided.
FIG. 11 is a schematic structural view of a stacked grid solar cell sheet in which a stacked grid structure is provided on the front surface, a conventional electrode structure is provided on the back surface, and two current collection structures are provided.
FIG. 12 is a schematic structural view of a stacked grid solar cell sheet in which a stacked grid structure is provided on the front surface and a back electrode is provided on the back surface.

### Reference signs:

1 - cell sheet substrate; 2 - metal wire; 3 - current collection structure; 4 - finger; 5 - busbar.

### BEST EMBODIMENTS OF THE PRESENT INVENTION

### EMBODIMENTS OF THE PRESENT INVENTION

### DETAILED DESCRIPTION OF THE EMBODIMENTS

The present invention will be further described in detail below with reference to drawings and embodiments, but the protection scope of the present invention is not limited thereto.

### Examples:

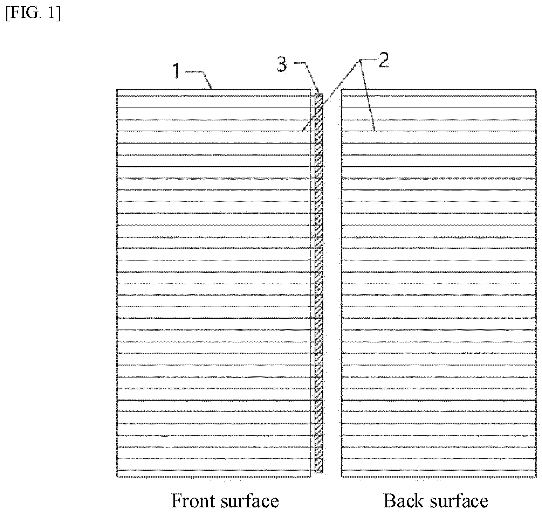

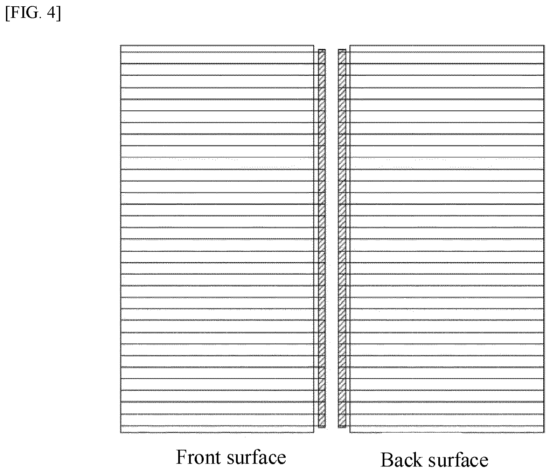

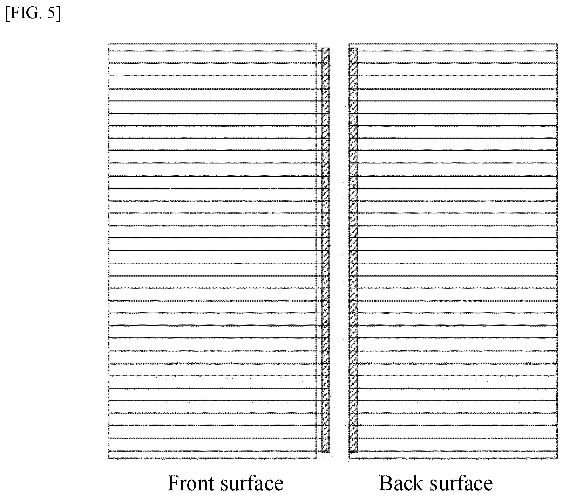

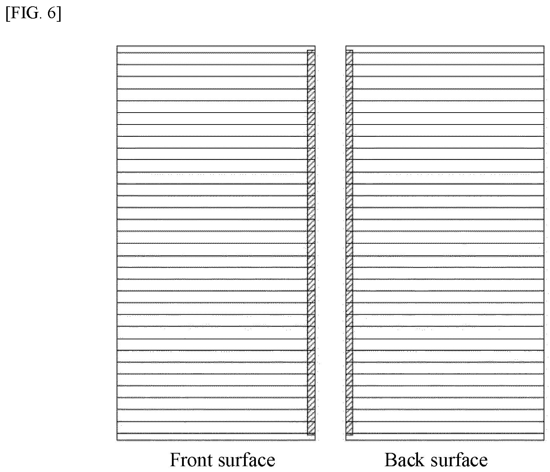

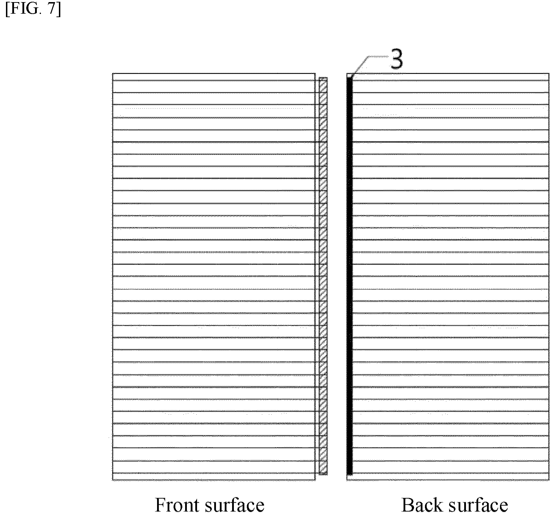

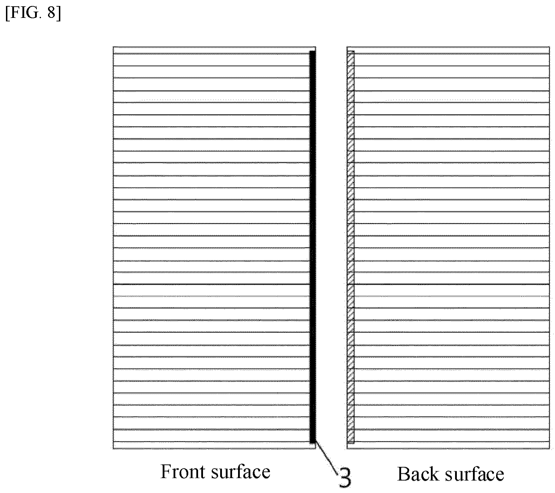

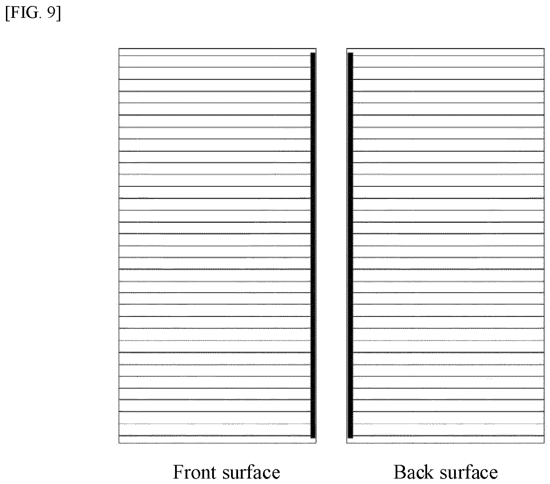

As shown in FIG. 1 to FIG. 12, the present invention provides a stacked grid solar cell sheet, including a cell sheet substrate 1. The cell sheet substrate 1 has a shape of a rectangle, and a length of a shorter side of the rectangle is 1/3 to 2/3 of a length of a longer side of the rectangle. Preferably, the length of the shorter side is about half the length of the longer side. A stacked grid structure is provided on a first surface of the cell sheet substrate 1. The stacked grid structure includes grid lines and metal wires 2, where the grid lines are provided on the cell sheet substrate 1 and distributed parallel to each other at equal intervals, and the metal wires 2 respectively cover the grid lines. A second stacked grid structure, a conventional electrode structure, or a back electrode is provided on a second surface of the cell sheet substrate. At least one current collection structure 3 is provided on the cell sheet substrate 1. A current collection structure 3 of the at least one current collection structure 3 is perpendicularly connected to the metal wires 2.

In a specific implementation, the metal wires 2 are located within the cell sheet substrate 1 or extend beyond the cell sheet substrate 1. A length by which the metal wires 2 extend beyond the cell sheet substrate 1 is adjustable as necessary. When the metal wires 2 extend beyond the cell sheet substrate 1, the current collection structure 3 is soldered to portions of the metal wires 2 extending beyond the cell sheet substrate 1. When the metal wires 2 are located within the cell sheet substrate 1, the current collection structure 3 is soldered within the cell sheet substrate 1.

The at least one current collection structure 3 includes any one selected from the group consisting of a bus ribbon, a silver electrode, an electrically conductive adhesive, and an electrically conductive tape. The bus ribbon is connected to the metal wires 2 by soldering. The soldering includes any one selected from the group consisting of a manual soldering, a tabbing with a stringing machine, a roller winding-soldering, and a novel soldering.

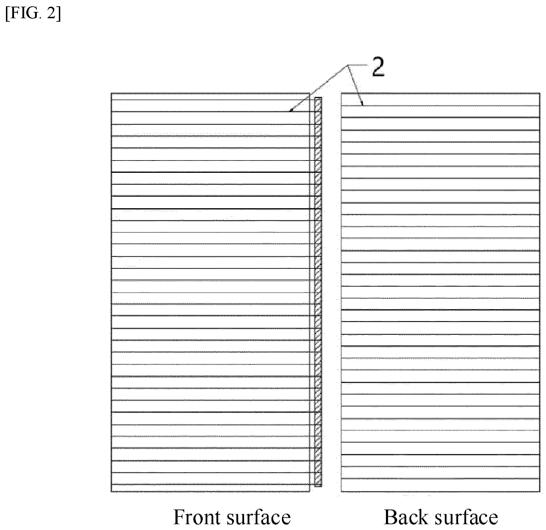

In a specific implementation, when the stacked grid structure is provided on the first surface of the cell sheet substrate 1 of the stacked grid solar cell sheet and the second stacked grid structure is provided on the second surface of the cell sheet substrate 1 of the stacked grid solar cell sheet, the metal wires 2 on the first surface are staggered with metal wires 2 on the second surface. As shown in FIG. 1 and FIG. 2, in order to prevent the metal wires 2 on the front surface from overlapping and interfering with the metal wires 2 on the back surface to affect the quality of series connection during the series connection process of cell sheets, the metal wires 2 on the front surface may be designed to be staggered with the metal wires 2 on the back surface, such that the metal wires 2 on the front surface are exactly located in gaps between the metal wires 2 on the back surface when overlapping, or the cell sheet substrate 1 is placed to be staggered as a whole by half a pitch between the metal wires 2, such that the metal wires 2 on the front surface are staggered with the metal wires 2 on the back surface.

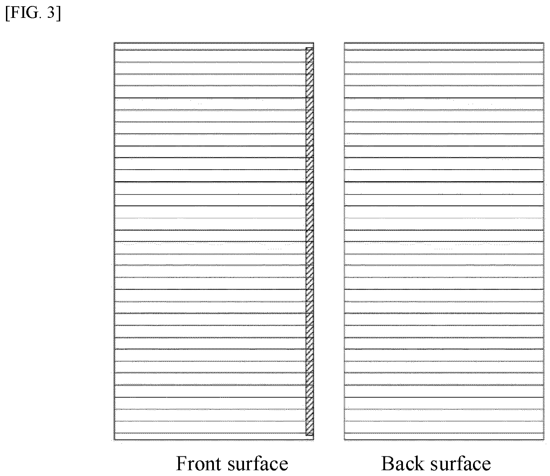

As shown in FIG. 3 to FIG. 9, the metal wires 2 of the stacked grid solar cell sheet may extend beyond the cell sheet substrate 1 or may be located within the cell sheet substrate 1. When the metal wires 2 extend beyond the cell sheet substrate 1, the current collection structure 3 is arranged at portions of the metal wires 2 extending beyond the cell sheet substrate 1. When the metal wires 2 are located within the cell sheet substrate 1, the current collection structure 3 is arranged within the cell sheet substrate 1. The current collection structure 3 may be a bus ribbon or a silver electrode.

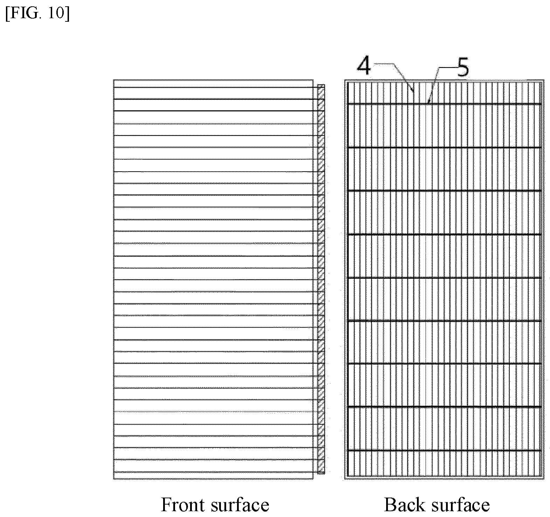

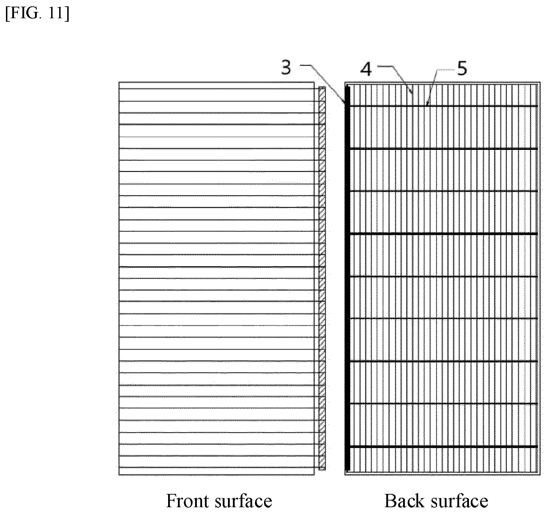

In a specific implementation, as shown in FIG. 10 and FIG. 11, when the stacked grid structure is provided on the first surface of the cell sheet substrate 1 and the conventional electrode structure is provided on the second surface of the cell sheet substrate 1, one or two current collection structures 3 are provided on the cell sheet substrate 1. When the one current collection structure 3 is provided, the one current collection structure 3 is perpendicularly connected to the metal wires 2 of the stacked grid structure, and when the two current collection structures 3 are provided, the two current collection structures 3 are perpendicularly connected to the metal wires 2 of the stacked grid structure and busbars 5 of the conventional electrode structure, respectively.

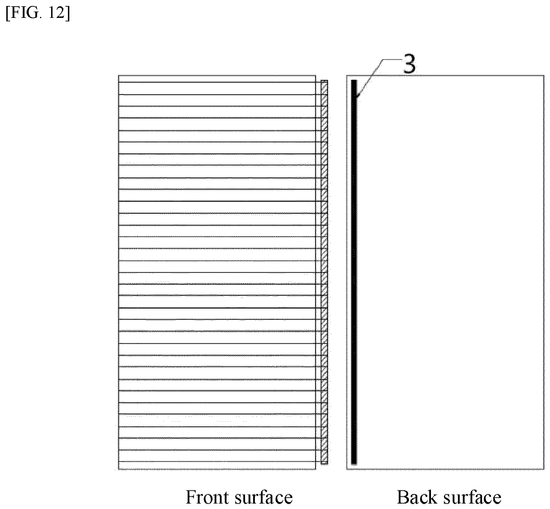

In a specific implementation, as shown in FIG. 12, when the stacked grid structure is provided on the first surface of the cell sheet substrate 1 and the back electrode is provided on the second surface of the cell sheet substrate 1, two current collection structures 3 are provided on the cell sheet substrate 1. One of the two current collection structures 3 is perpendicularly connected to the metal wires 2 of the stacked grid structure, and the other of the two current collection structures 3 is arranged on the back electrode.

In a specific implementation, the stacked grid solar cell sheet may be processed to manufacture a solar cell. The solar cell includes any one selected from the group consisting of a passivated emitter and rear contact (PERC) solar cell, a tunnel oxide passivated contact (TOPCon) solar cell, a heterojunction with intrinsic thin layer (HJT) solar cell, and an interdigitated back contact (IBC) solar cell. Further, a photovoltaic module may be obtained by stringing at least two cell units. Each of the at least two cell units includes the stacked grid solar cell sheet or any one of the solar cells as described above. During stringing, two adjacent ones of the at least two cell units are connected via the current collection structure 3. A current collection structure 3 of a cell unit of the at least two cell units is connected to metal wires 2 or a current collection structure 3 of a subsequent adjacent cell unit of the at least two cell units by soldering, such that the current collection structure 3 of the cell unit is arranged between the cell unit and the subsequent adjacent cell unit or is arranged on the subsequent adjacent cell unit.

The embodiments are preferred embodiments of the present invention, but the present invention is not limited to the above-mentioned embodiments. Any apparent improvement, replacement, or variation that can be made by those skilled in the art without departing from the spirit of the present invention shall fall within the protection scope of the present invention.

## Claims

1. A stacked grid solar cell sheet, **characterized by** comprising a cell sheet substrate (1),
wherein a stacked grid structure is provided on a first surface of the cell sheet substrate (1), and the stacked grid structure comprises grid lines and metal wires (2), wherein the grid lines are provided on the cell sheet substrate (1) and distributed parallel to each other at equal intervals, and the metal wires (2) respectively cover the grid lines;
a second stacked grid structure, a conventional electrode structure, or a back electrode is provided on a second surface of the cell sheet substrate (1); and
at least one current collection structure (3) is provided on the cell sheet substrate (1), and a current collection structure (3) of the at least one current collection structure (3) is perpendicularly connected to the metal wires (2).

2. The stacked grid solar cell sheet according to claim 1, **characterized in that** the cell sheet substrate (1) has a shape of a rectangle, and a length of a shorter side of the rectangle is 1/3 to 2/3 of a length of a longer side of the rectangle.

3. The stacked grid solar cell sheet according to claim 1, **characterized in that** the metal wires (2) are located within the cell sheet substrate or extend beyond the cell sheet substrate.

4. The stacked grid solar cell sheet according to claim 3, **characterized in that** a length by which the metal wires (2) extend beyond the cell sheet substrate (1) is adjustable as necessary.

5. The stacked grid solar cell sheet according to claim 3, **characterized in that** when the metal wires (2) extend beyond the cell sheet substrate, the current collection structure (3) is soldered to portions of the metal wires (2) extending beyond the cell sheet substrate; and
when the metal wires (2) are located within the cell sheet substrate, the current collection structure (3) is soldered within the cell sheet substrate.

6. The stacked grid solar cell sheet according to claim 1, **characterized in that** the at least one current collection structure (3) comprises any one selected from the group consisting of a bus ribbon, a silver electrode, an electrically conductive adhesive, and an electrically conductive tape.

7. The stacked grid solar cell sheet according to claim 6, **characterized in that** the bus ribbon is connected to the metal wires (2) by soldering, and the soldering comprises any one selected from the group consisting of a manual soldering, a tabbing with a stringing machine, a roller winding-soldering, and a novel soldering.

8. The stacked grid solar cell sheet according to claim 1, **characterized in that** when the stacked grid structure is provided on the first surface of the cell sheet substrate (1) of the stacked grid solar cell sheet and the second stacked grid structure is provided on the second surface of the cell sheet substrate (1) of the stacked grid solar cell sheet, the metal wires (2) on the first surface are staggered with metal wires (2) on the second surface.

9. The stacked grid solar cell sheet according to claim 1, **characterized in that** when the stacked grid structure is provided on the first surface of the cell sheet substrate (1) and the conventional electrode structure is provided on the second surface of the cell sheet substrate (1), one or two current collection structures (3) are provided on the cell sheet substrate (1);
when the one current collection structure (3) is provided, the one current collection structure (3) is perpendicularly connected to the metal wires (2) of the stacked grid structure; and
when the two current collection structures (3) are provided, the two current collection structures (3) are perpendicularly connected to the metal wires (2) of the stacked grid structure and busbars (5) of the conventional electrode structure, respectively.

10. The stacked grid solar cell sheet according to claim 1, **characterized in that** when the stacked grid structure is provided on the first surface of the cell sheet substrate (1) and the back electrode is provided on the second surface of the cell sheet substrate (1), two current collection structures (3) are provided on the cell sheet substrate (1), wherein one of the two current collection structures (3) is perpendicularly connected to the metal wires (2) of the stacked grid structure, and the other of the two current collection structures (3) is arranged on the back electrode.

11. A solar cell, **characterized by** comprising the stacked grid solar cell sheet according to any one of claims 1 to 10.

12. The solar cell according to claim 11, **characterized in that** the solar cell comprises a passivated emitter and rear contact (PERC) solar cell, a tunnel oxide passivated contact (TOPCon) solar cell, a heterojunction with intrinsic thin layer (HJT) solar cell, or an interdigitated back contact (IBC) solar cell.

13. A photovoltaic module, **characterized in that** the photovoltaic module is obtained by stringing at least two cell units, wherein each of the at least two cell units comprises the stacked grid solar cell sheet according to any one of claims 1 to 10 or the solar cell according to any one of claims 11 to 12.

14. The photovoltaic module according to claim 13, **characterized in that** two adjacent ones of the at least two cell units are connected via the current collection structure (3), wherein a current collection structure (3) of a cell unit of the at least two cell units is connected to metal wires (2) or a current collection structure (3) of a subsequent adjacent cell unit of the at least two cell units by soldering.

15. The photovoltaic module according to claim 14, **characterized in that** the current collection structure (3) of the cell unit is arranged between the cell unit and the subsequent adjacent cell unit or is arranged on the subsequent adjacent cell unit.
